# EUROPEAN PATENT APPLICATION

(11) **EP 4 844 421 A1**
(43) Date of publication of application: **25.11.2026**
(21) Application number: 26178059.7
(22) Date of filing: 11.05.2026
(51) Int. Cl.: G01R 31/26, G01R 31/265, G01R 31/302

(54) **WIDE BANDGAP SEMICONDUCTOR CHARACTERIZATION USING CORONA SURFACE CHARGE NEUTRALIZATION BY UV RADIATION IN PULSED AND CONTINUOUS MODES**

(30) Priority: 12.05.2025 US 202519206003; 17.11.2025 US 202519391972
(71) Applicant: Onto Innovation SDI LLC, Tampa, Florida 33637 (US)
(72) Inventor: WILSON, Marshall D, Tampa, 33637 (US); ALMEIDA, Carlos, Tampa, 33637 (US); SHEKEROV, Ivan, Tampa, 33637 (US); LAGOWSKI, Jacek, Tampa, 33637 (US); SCHRAYER, Bret, Tampa, 33637 (US); GUTIERREZ-HERNANDEZ, Liliana, Tampa, 33637 (US); WINCUKIEWICZ, Adam, Tampa, 33637 (US)
(74) Representative: EIP

(57) **Abstract**

A system for and method of characterizing a semiconductor sample include: depositing a corona charge on a surface of the semiconductor sample; irradiating a region with ultraviolet (UV) radiation for a duration, t, to neutralize the deposited corona charge; measuring a time resolved surface voltage, *V*, response to the UV irradiation at the region; and determining values of one or more parameters of the semiconductor sample at the region based on the duration of the UV irradiation, t, and the time resolved surface voltage, *V*, and at least one of a value of a neutralized corona charge, Δ*Q*, and a differential capacitance value, *C*.

## Description

### CROSS-REFERENCE TO RELATED APPLICATIONS

This application is a continuation-in-part application of and claims the benefit of priority to U.S. Application No. 19/206,003, titled "WIDE BANDGAP SEMICONDUCTOR CHARACTERIZATION BASED ON CAPACITANCE CHARACTERISTICS ACQUIRED USING CORONA SURFACE CHARGE NEUTRALIZATION BY UV RADIATION PULSES," filed on May 12, 2025, the contents of which are hereby incorporated by reference.

### TECHNICAL FIELD

This application generally relates to non-invasive electrical testing of wide bandgap semiconductor materials and structures, and more particularly, to methods and systems for noncontact measurement of electrical characteristics of epitaxial layers and of high electron mobility transistor structures.

### BACKGROUND

Electrical characterization of semiconductor materials and structures is a necessary element for development of semiconductor devices and for optimizing and controlling the manufacturing process. Rapidly growing semiconductor applications for power electronics and high-speed devices, are based on high-cost wide bandgap wafers with epitaxial layers, such as, SiC, Ga₂O₃, GaN, AlGaN, or AlGaN/GaN structures. Mass epi-layer testing is needed to scale this progressing technology. A cost and time effective non-contact version of the wafer level electrical metrology can be especially beneficial for this purpose. Noncontact characterization can eliminate the need for fabrication of test devices, test capacitors, and the use of destructive or contaminating contacts.

An example of a non-contact capacitance measurement suitable for wide bandgap semiconductor wafers is described in U.S. Pat. No. 10,969,370B2. Such measurements can be performed with commercially available Corona non-contact Capacitance Voltage (CnCV) tools manufactured by Semilab SDI. CnCV uses corona charging to electrically bias the surface of a semiconductor instead of the voltage biasing of a gate electrode contacting the semiconductor.

A non-contact determination of capacitance in CnCV method is realized with incremental deposition of precise corona charge doses Δ*Q_{C}* and non-contact Kelvin probe measurement of the surface voltage response, *ΔV.* Differential capacitance values *C =* Δ*Q_{C}*/Δ*V* in a series of corona charging-voltage measuring steps give a capacitance-voltage, *C* - *V*, characteristic. In addition, this technique gives charge-voltage, *Q - V* and capacitance-charge *C* - *Q* characteristics obtained with cumulative charge values. Electrical parameters are then determined using the standard procedures developed for these characteristics and described in literature. In the present disclosure, example applications include a determination of dopant concentration in SiC epi-layers and a determination of AlGaN/GaN HEMT (High Electron Mobility Transistor) structure parameters, such as, the pinch off voltage, the density of the high mobility two-dimensional electron gas (2DEG) at the AlGaN/GaN interface, the electron mobility in the 2DEG and the AlGaN layer thickness.

Rapidly growing power and high frequency electronics demands for SiC and AlGaN/GaN epi-wafers has created a special need for increasing the throughput in CnCV measurements. In standard CnCV, the multi-step incremental charge deposition and surface voltage measurement sequence provides limitations for the measurement speed and wafer throughput well below industry requirement of typical 20 wafers/h. A recent development of accelerated doping measurement described in U.S. Pat. No. 12,027,430B1 and US 12,154,833B2 introduced fast kinetic measurement based on exponential photoneutralization of corona deposited charge. This method available as the kinetic mode in modified CnCV tools introduces new determination of dopant concentration from a measured value of the photoneutralization time constant. However, it is limited to doping and does not improve either the capacitance-voltage based measurements nor characterization of AlGaN/GaN HEMT structures.

### SUMMARY

A high throughput C-V measurement approach is described here. This approach takes advantage of a linear charge photo-neutralization technique discovered for short wavelength UV radiation with a penetration depth much shallower than that used for the exponential photo-neutralization process. In the linear neutralization technique, the corona charge neutralized on the semiconductor surface is exactly proportional to the UV irradiation time. The technique provides an alternative to incremental corona charging. Such UV-induced electrical biasing can be faster, and it can be useful also for measurements of other electrical characteristics, not only C-V.

This disclosure further includes techniques that include the acquisition of charge-voltage characteristics and measurements in a configuration with a continuous UV irradiation mode. Such techniques can be especially beneficial for high resolution, high speed testing of high electron mobility transistor (HEMT) structures.

Accordingly, the present disclosure relates to noncontact, noninvasive characterization of the electrical properties of wide bandgap semiconductors and structures, suitable for high throughput wafer testing. In certain implementations, the C-V technique, based on a principle of linear corona charge neutralization, uses a rapid sequence of charge steps produced by a pulsed UV irradiation mode with, e.g., 235 nm wavelength millisecond duration pulses. This approach can benefit throughput as well as resolution and precision. In certain embodiments, it can be extended to the acquisition of capacitance-charge and charge-voltage characteristics, expanding the metrology applications.

This approach can enable change of the corona charge on the surface in precise charge steps, Δ*Q* , created by pulses of UV radiation under a condition wherein Δ*Q*is linear with the UV pulse duration, Δ*tₚ.* Measuring the surface voltage, V, and the increments, *ΔV,* corresponding to the charge steps gives the C-V characteristic with determination of the differential capacitance as $C = \frac{{f}_{cal} Δ {t}_{p}}{ΔV}$ where *f_{cal}* is the calibration constant. The *f_{cal}* depends upon the incident UV photon flux. In the linear range *f_{cal}* is independent of duration time and is the same for pulsed and continuous irradiation. Cumulative UV irradiation time, *t* = Σ Δ*tₚ* gives the cumulative change of charge as *Q* = *f_{cal}* · *t* enabling determination of Q-V from the measured (*t;V*) characteristics.

In general, the technique uses an initial deposition of corona charge of an appropriate dose and polarity to deplete the surface space charge region of free carriers. This is realized by placing negative charge on n-type semiconductors and positive charge on p-type semiconductors, respectively. In wide bandgap semiconductors the surface space charge region depleted of free carriers isolates the surface from the conducting bulk region. Due to the wide bandgap there is little to no thermal generation of excess carriers within the depletion region in the dark. This provides corona charge stability in the dark on bare epi-wafers, enabling delayed measurement of the surface voltage response with movement of the wafer between UV radiation, neutralizing the charge and the probe measuring the surface voltage before and after charge neutralization.

The conventional corona noncontact C-V technique in CnCV tools measures static differential capacitance determined as *C = ΔQ_{C}* / *ΔV.* By way of contrast, a measuring method described in US10,969,370B2 uses constant surface potential corona charging that involves adjustment of the surface potential at a region of a surface to the prescribed target value before each charging step in the entire sequence of measuring the capacitance-voltage characteristic. This generally consumes time and affects the measuring speed. The speed limitation in standard CnCV is also due to relatively slow corona charge deposition in the charging steps. The corona charging process involves high voltage application to a corona electrode that creates ${CO}_{3}^{-}$ and *H₃O*⁺ ionic charge species for negative and positive corona, respectively. The ions move from the corona source by diffusion. The short ion free path (about 10⁻⁵cm) in atmospheric ambient used in corona charging results in the thermalization of ions in multiple collisions before noninvasive deposition on the surface. A constant surface potential method can reduce electrostatic interaction between diffusing and already deposited corona ions. This can increase precision but can slow down the measurement process in sequences using multiple corona charging steps.

The corona charge deposition step can typically take about 0.5 seconds and as many as 200 steps can be used for high resolution C-V. Wafer testing uses C-V characteristics at 9 to 49 test sites on the wafers. Corresponding total charging time is an important throughput limitation.

In linear UV charge neutralization, corona ions are neutralized on the surface by capturing minority carriers generated near the surface. The process is fast and accurate. It enables a C-V measurement with short (e.g., 0.5 milliseconds to 10 milliseconds) duration charge pulses compared to 500 milliseconds in standard CnCV. This approach can give about two orders of magnitude reduction of time needed to create a sequence of charge steps used for characterization of AlGaN/GaN HEMT structures.

A principle of the measurement techniques described here is based, at least in part, on the finding that for sufficiently short UV radiation wavelength and corresponding short UV penetration depth, the magnitude of neutralized charge, Δ*Q_{C}*, can depend linearly on the duration of the UV irradiation. In measurement of SiC or GaN bare epi-layers, for example, this linear dependance can be satisfied when the UV penetration depth in a semiconductor is much smaller than the width of depleted surface space charge region. In measurement of AlGaN/GaN HEMT structures, the linear charge neutralization condition can be satisfied when incident UV photons are sufficiently absorbed within the top AlGaN barrier layer of the structure. In practice, UV wavelength equal to or shorter than about 250 nm can be sufficient in both cases. An example of an appropriate radiation source is a LED with a 235 nm wavelength.

The linear charge neutralization applied in the pulsed UV irradiation mode enables the use of a UV pulse duration Δ*tₚ,* as an indicator of the charge increment value, *ΔQ* in relative units. This provides a way to determine the capacitance value in relative units as *Cᵣₑₗ* = *Δtₚ*/*ΔV,* where *ΔV* is the change of surface voltage in response to the UV radiation pulse measured with the Kelvin probe as the difference in surface voltage value, *V*, after and before the UV pulse i.e. *ΔV* = *V_{after} - V_{before}.* The capacitance value *C* in C-V corresponds to the average voltage *V* = (*V_{after} - V_{before}*)/2. For capacitance quantification, the method can incorporate calibration of the UV pulse duration and the charge, *ΔQ = f_{cal}* · Δ*tₚ,* enabling conversion of the relative capacitance to capacitance in absolute units. The calibration factor *f_{cal}* can be determined for a given semiconductor wafer for a specific UV radiation condition: the wavelength λ, and the effective photon flux, *Φ_{eff}* = (1 - *R) Φ* entering the semiconductor *Φ_{eff}* = (1 - *R*) *Φ*where *R* is the reflection coefficient and *Φ* is the incident photon flux.

Based on the linear charge neutralization phenomenon, the charge can be conveniently varied by changing the photon flux or by changing the duration of the UV radiation pulses. This can enable the optimization of the measurement speed and resolution. A practically important example includes adjusting the UV pulse duration during the measurement to produce variable charge increments in the acquisition of C-V characteristics. Corresponding applications may include two frequently measured cases, such as: (1) measurement of epi-wafers with multiple layers of different dopant concentration values, and (2) characterization of AlGaN/GaN HEMT structures that typically include low and high capacitance segments corresponding to a depopulated and populated 2DEG, respectively. The optimized measurement is realized using different duration pulses of UV radiation in different C-V segments. Short pulses can be used for low doping/low capacitance segments, while longer pulses can be used for high doping/high capacitance segments. Alternately, different photon fluxes can be used for different segments.

An additional advantage of UV radiation over standard CnCV charge deposition steps relates to the fact that it can be used directly under the Kelvin probe. In this case, the movement of the Kelvin probe up by about 2 mm, for example, can facilitate uniform radiation during the UV pulse, while movement of the probe down to an optimal measurement distance, typically 0.2 mm above the wafer surface, can benefit the precision of the *ΔV* determination. The probe movement can be faster than the lateral wafer transfer needed in the case of UV radiation at separate locations.

While the foregoing implementations utilize pulsed UV radiation, more generally, the techniques described here are not so limited. For example, in some implementations, surface voltage measurements can be performed during continuous UV irradiation. For example, a configuration with a 1 mm to 2 mm diameter kelvin probe can enable realization of measurements with good surface voltage precision and uniform irradiation under the probe for a constant probe-surface distance in the range from 0.8 mm to 1.0 mm. For this configuration, probe movements up and down can be eliminated, enabling the use of the continuous UV irradiation mode with continuous measurement of the surface voltage response, *V* , during continuous irradiation. The irradiation time, *t*, can be used as a relative measure of the neutralized corona charge and *t* vs. *V* data provide the charge-voltage characteristic in relative units. Implementations of a continuous UV radiation mode with different photon fluxes for different segments of the measurement can be especially beneficial for characterization of AlGaN/GaN HEMT structures. For a typical nine wafer site measurement with determination of three HEMT parameters, namely, the pinch-off voltage, *V_{P}*, the density of two-dimensional electron gas, *N*₂*_{DEG},* and the AlGaN barrier layer thickness, this method can satisfy the industry requirement of throughput of 20 wafers/h compared to only 2 wafers/h throughput typical for characterization using sequential corona charge deposition in the standard CnCV technique.

The methods described here are generally intended for electrical characterization of wide bandgap semiconductors, such as, for instance, SiC, GaN, AlGaN, Ga₂O₃ and wide bandgap structures such as an AlGaN/GaN HEMT structure. The methods are noncontact and can be performed without fabrication of any test devices or contacts on the test wafer. They can be implemented with appropriately modified hardware for CnCV tools.

Systems for characterizing semiconductor electrical properties according to the described methods can be implemented in a CnCV apparatus that includes:
(1) a surface voltage measurement probe;
(2) a corona charging source for depositing a prescribed dose of negative or positive charge on the surface to deplete the wide bandgap semiconductor wafer surface space charge region;
(3) a UV radiation source at the border of the far ultraviolet spectral range such as, for instance, 235 nm wavelength appropriate for linear corona charge neutralization in pulsed UV irradiation mode and/or in continuous UV irradiation mode. The UV radiation source is configured to neutralize charge on wide bandgap semiconductor surfaces, as well as on the surface of AlGaN/GaN HEMT structures at the region positioned under the surface measurement probe, or at a separate position;
(4) a moveable chuck configured to support the semiconductor wafer/sample relative to the surface voltage probe, the corona charge source, and the UV radiation source; and
(5) a computer controller in communication with the elements of the apparatus and programmed to cause the system to perform measurements in pulsed and/or continuous UV irradiation modes to carry out determination of electrical characteristics based on irradiation time vs. surface voltage data. In addition, the computer controller is configured to carry out determination of electrical parameters of wide bandgap semiconductor materials and structures.

Other features and advantages will be apparent from the drawings, description, and the claims.

### BRIEF DESCRIPTION OF DRAWINGS

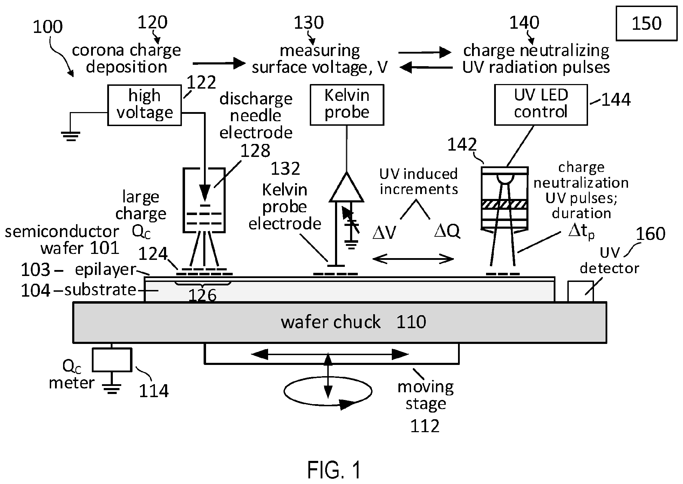

**FIG. 1** is a schematic diagram of an example CnCV apparatus for wide band gap (WBG) semiconductor characterization incorporating a pulsed UV irradiation mode for corona charge neutralization;

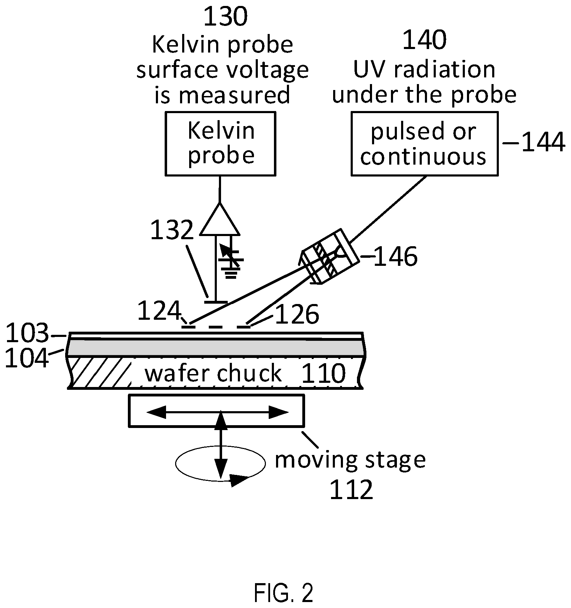

**FIG. 2** is a schematic diagram of a portion of the CnCV apparatus showing an arrangement for corona charge neutralization by UV radiation under a Kelvin probe that can be used for both pulsed and continuous UV irradiation modes;

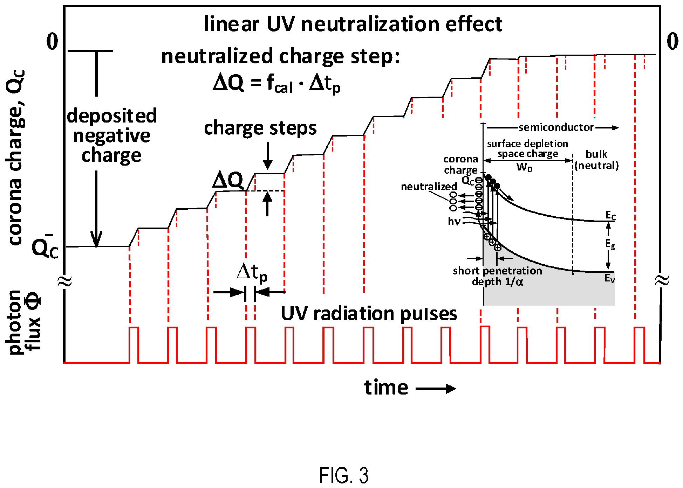

**FIG. 3** is a plot of corona charge as a function of time showing sequential corona charge neutralization steps created by UV radiation pulses in a pulsed UV irradiation mode. The insert shows a semiconductor energy band diagram illustrating the mechanism of linear corona charge neutralization by free holes generated by UV radiation within a UV penetration depth shorter than the width of the surface depletion;

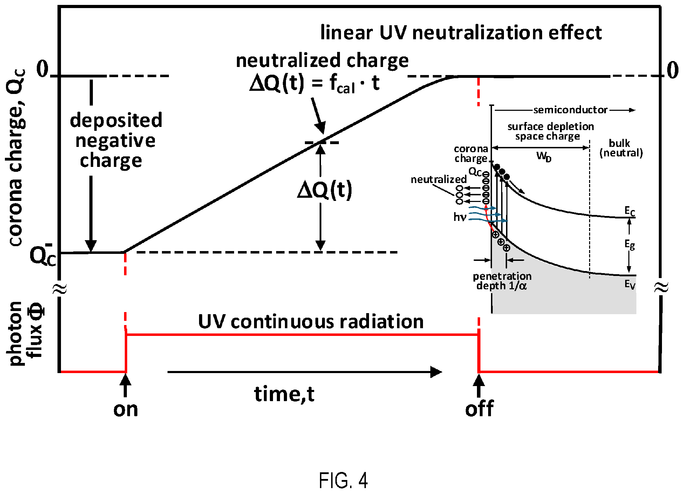

**FIG. 4** is a plot of linear corona charge neutralization with time in a continuous UV irradiation mode. The insert illustrates the charge neutralization mechanism, similar to that in FIG. 3;

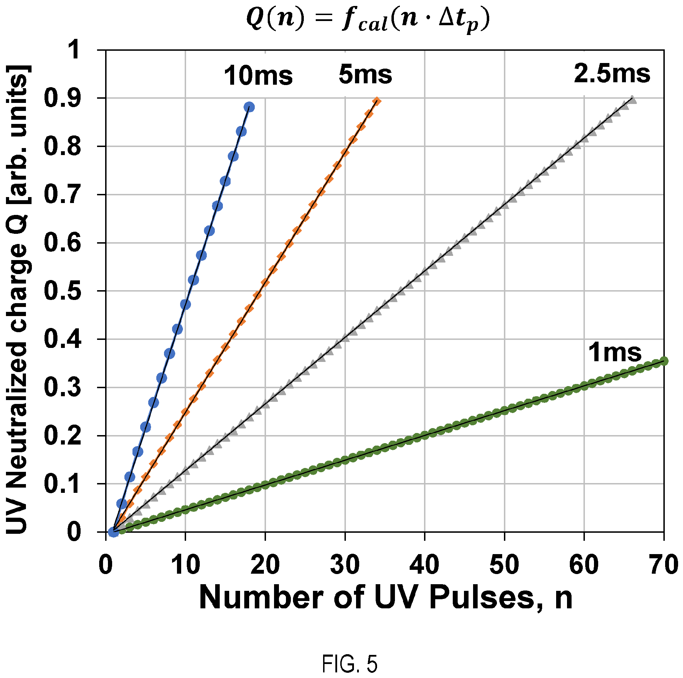

**FIG. 5** is a plot of UV neutralized charge vs. number of UV radiation pulses, *n*, showing sequential corona charge linear neutralization in a pulsed UV irradiation mode with different pulse durations Δ*tₚ* measured at a constant incident photon flux. The results illustrate a linear increase of the neutralized corona charge magnitude with number of pulses, *n* and with pulse duration, Δ*tₚ*;

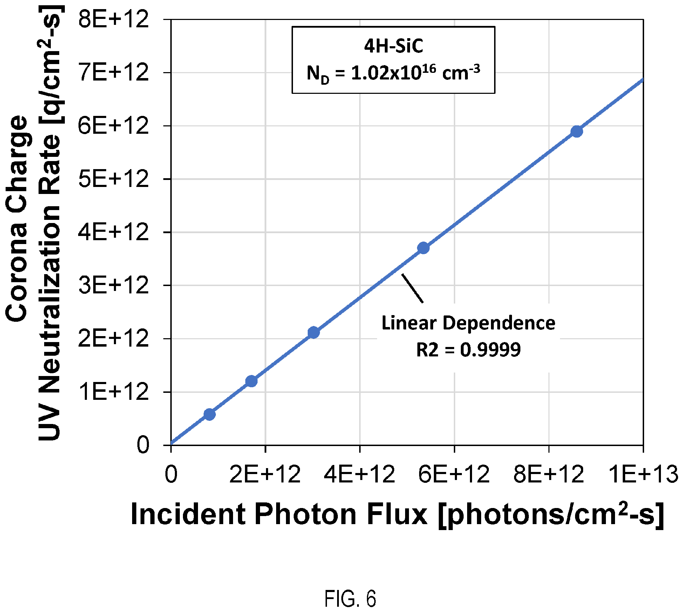

**FIG. 6** is a plot of the UV irradiation induced corona charge neutralization rate (Δ*Q*/Δ*t*) versus the incident photon flux measured in a continuous UV irradiation mode. This plot demonstrates the linear dependence of the rate on the incident photon flux with a correlation coefficient with *R*² = 0.9999. The neutralization rate equals the calibration constant, *f_{cal}*, for the given photon flux and it is the same for continuous and pulsed UV irradiation modes.

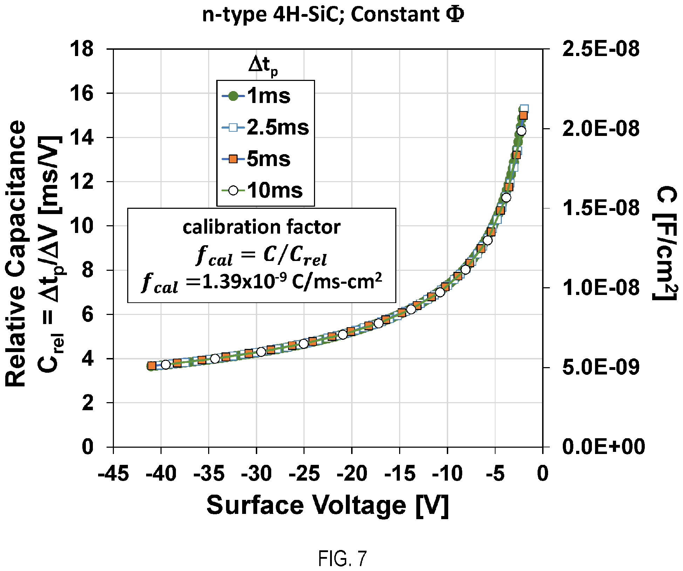

**FIG. 7** is a plot illustrating C-V characteristics of a single doping epitaxial layer measured according to the described method using a pulsed UV irradiation mode with different pulse durations Δ*tₚ* from 1 ms to 10 ms. The relative unit differential capacitance, *Cᵣₑₗ,* can be converted to absolute capacitance, *C*, using the calibration factor, *f_{cal}*.

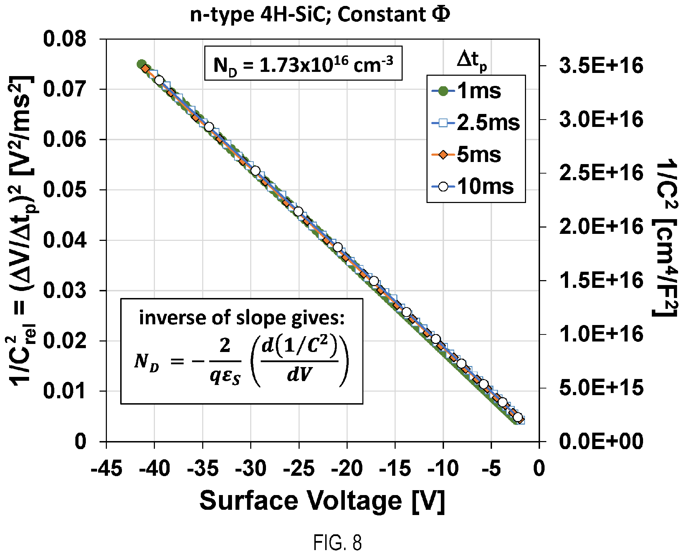

**FIG. 8** is a plot based on results in FIG. 7 illustrating the application of the linear corona charge UV neutralization method to doping characterization for a n-type SiC wafer showing $\frac{1}{{C}^{2}} vs V$ plot with the inverse of the slope giving the dopant concentration N_{D};

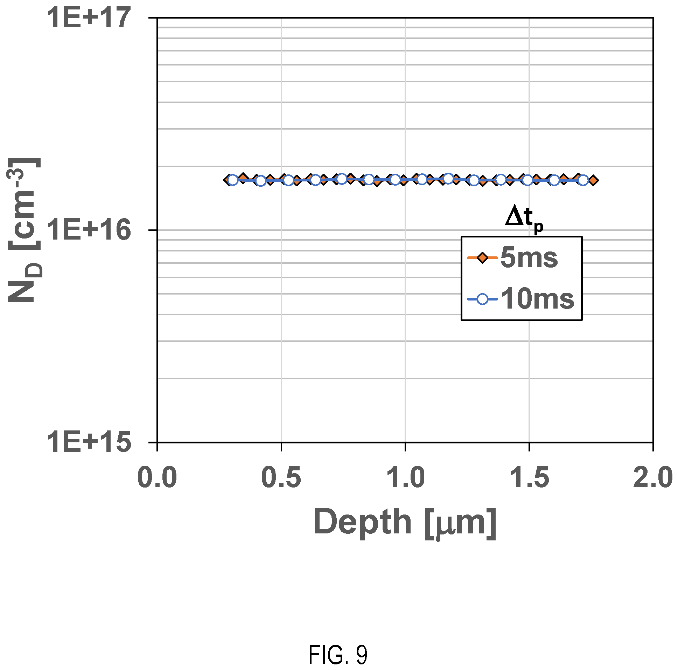

**FIG. 9** is an example of a uniform dopant depth profile corresponding to the example measurement illustrated in FIG. 7 and FIG. 8; shorter pulse duration, Δ*tₚ* results in better resolution in profiling. The depth values correspond to the width of the depletion layer, *W_{D},* determined from the differential capacitance using Eqn. b (in the detailed description) and a dielectric constant of 9.6 for the measured 4H-SiC.

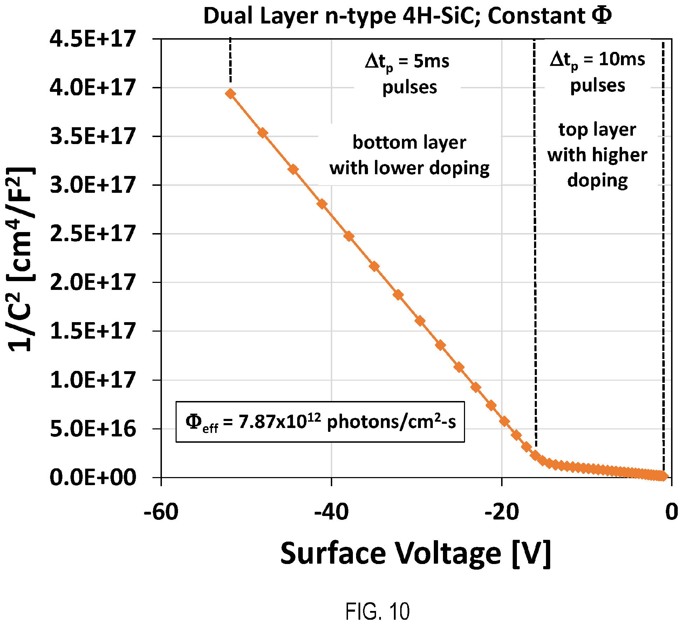

**FIG. 10** is a 1/*C*² *vs V* plot showing results for a SiC epi-wafer with two different doping layers obtained with the linear corona charge UV neutralization method in a pulsed UV irradiation mode. Different slopes of the 1/*C*² plot correspond to differently doped layers measured with different UV pulse durations. Shorter 5 ms duration pulses are used for lower doping, while longer 10 ms duration pulses are for higher doping. The same photon flux was used for both pulse durations;

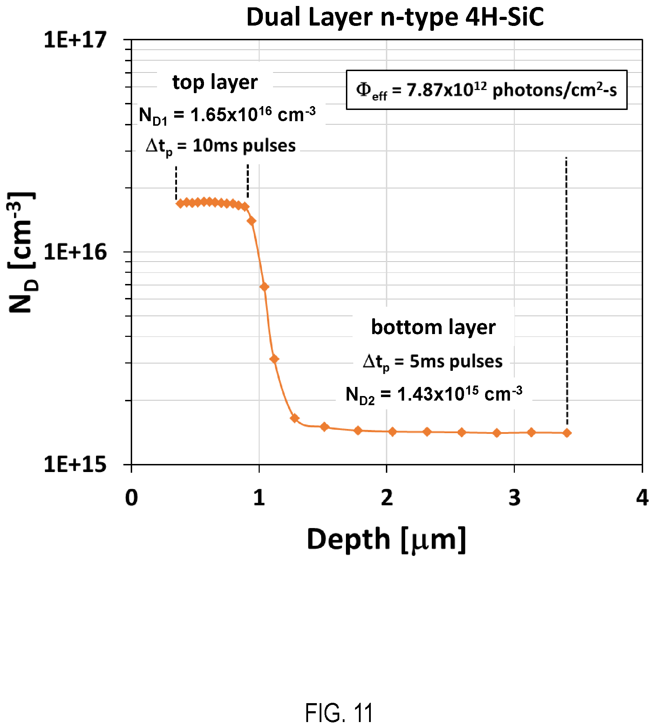

**FIG. 11** is a plot showing a doping depth profile in an epi-wafer with two differently doped layers measured using the described method with pulsed UV irradiation induced linear charge neutralization. Results correspond to the 1/*C*² plot in FIG. 10;

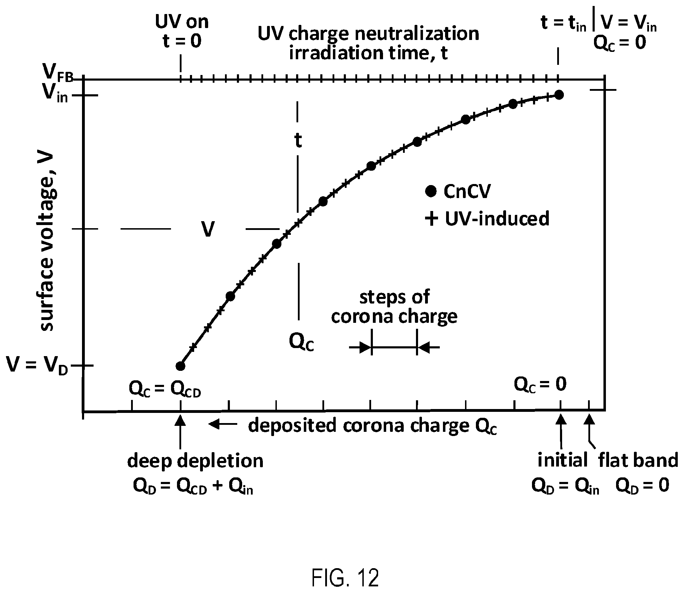

**FIG. 12** is a plot illustrating an example of the procedure using the UV irradiation induced linear corona charge neutralization mode for acquiring the irradiation time *t*, and the surface voltage *V,* and the charge *Q,* set of data (*t; V; Q*) and corresponding Schottky depletion layer charge, *Q_{D}.* The upper horizontal axis corresponds to irradiation time, *t,* of UV charge neutralization. The lower horizontal axis shows corona charging steps to deep depletion used in the CnCV technique. The initial values and deep depletion values illustrate Schottky barrier electrostatic parameters as discussed in the detailed description section;

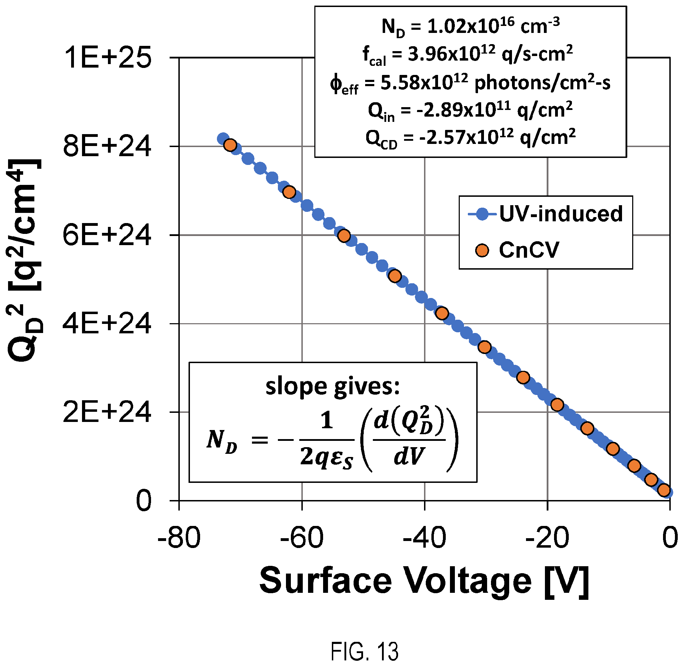

**FIG. 13** is a plot illustrating an example Q²-V doping measurement on n-type 4H-SiC. UV-induced results are based on charge-voltage characteristics acquired with linear UV irradiation-induced charge neutralization. The approach is validated by agreement with standard CnCV results of corona charge based Q²-V measurements done at the same wafer site. The UV-induced technique has a measurement time of 10s/site showing significant improvement over the CnCV measurement time of 40s/site;

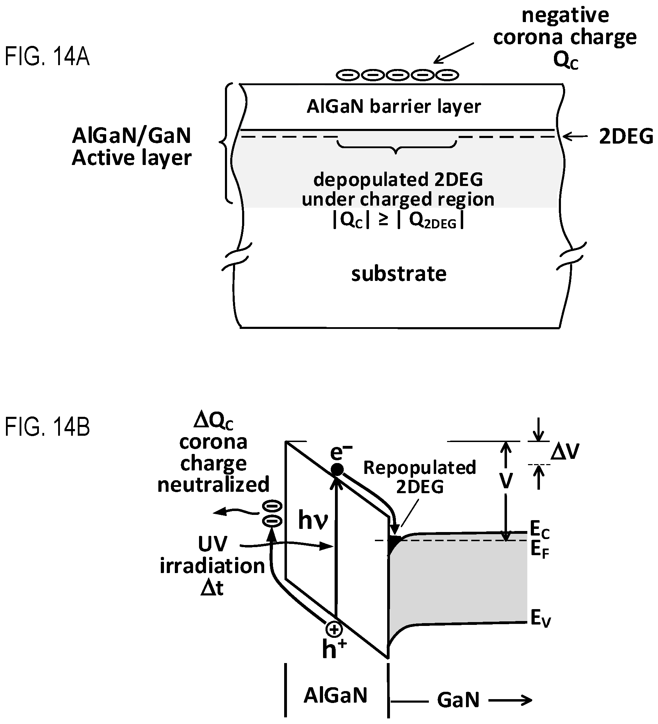

**FIG. 14A** is a schematic of an example AlGaN/GaN HEMT structure with the 2DEG (two dimensional electron gas) depopulated by corona charge;
**FIG. 14B** is a bandgap diagram illustrating the UV radiation induced corona charge neutralization effect causing repopulation of the 2DEG;

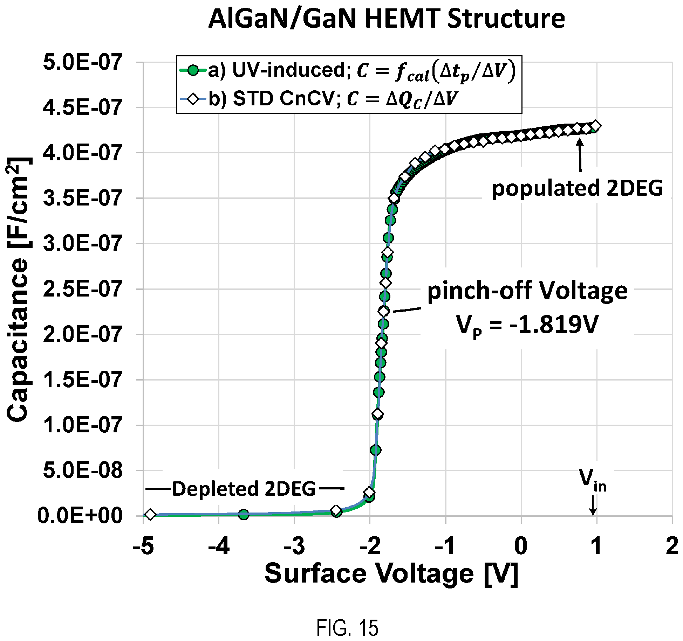

**FIG. 15** is a plot showing a UV-induced C-V characteristic of an AlGaN/GaN HEMT structure measured with UV radiation pulses according to the described method and calibration for absolute unit capacitance values. For comparison, a standard CnCV capacitance-voltage characteristic is shown measured with corona charging steps at the same wafer region as the UV based C-V; and

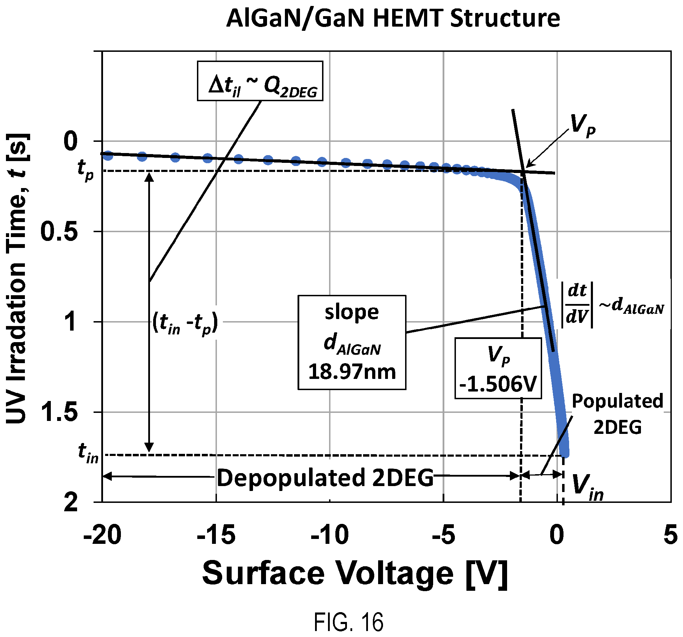

**FIG. 16** is a plot showing a UV-induced t-V characteristic of an AlGaN/GaN HEMT structure measured using a continuous UV irradiation mode.

In the drawings, like references denote like elements.

### DETAILED DESCRIPTION

Referring to FIG. 1, an example apparatus 100 for corona charge-voltage characterization of a semiconductor wafer sample 101 is shown schematically. The wafer sample includes a substrate 104 and an epitaxial layer 103 supported by the substrate 104. The apparatus 100 includes a corona charge source module 120 for precise charge 124 deposition on a surface region test site 126, a surface voltage measurement module 130 for surface voltage measurement with a vibrating electrode 132, ultra-violet radiation source module 140 for irradiating the wafer surface to neutralize deposited charge.

Wafer 101 is supported by a wafer chuck 110, which is positioned on a movable stage 112. Stage 112 can move the wafer chuck by translation, vertical movement, and rotation. A coulombmeter 114 is electrically connected to the wafer chuck 110.

The corona charge source module includes a corona discharge electrode 128 arranged to generate corona charge ionic species for deposition 124 on a site 126 on the surface of wafer 101. Surface voltage measurement module 130 includes a Kelvin probe that has an electrode 132 with calibrated work function, arranged to vibrate a small distance (e.g., a millimeter or less) above the surface of wafer 101. While the example described here uses a Kelvin probe, other capacitance probes can be used. For example, a Kelvin Force Microscopy (KFM) Probe can be used for high resolution application of the method.

UV radiation source module 140 includes a radiation source 142 arranged to irradiate the surface of the wafer 101 at a region 126 with prescribed radiation pulses. During operation, UV source 142 delivers pulses having a short wavelength suitable for linear neutralization of deposited corona charge in steps Δ*Q_{C}* of neutralized charge proportional to the UV pulse duration, Δtₚ and to the UV photon flux *Φ*. The photon flux can be measured using UV detector 160, preferably with NIST calibration. UV source 142 can include a UV emitting diode (UV LED) or a UV laser, for example. For a UV LED, the beam can be additionally monochromatized by passing through a narrow band pass filter. A diffuser can be added after the filter to improve the uniformity of the radiation.

UV radiation can be arranged to provide uniform radiation on the surface area of the corona charged spot, e.g. circular area spot about 10mm or less in diameter (e.g. about 6mm diameter).

The example apparatus 100 shown in FIG. 1 illustrates one configuration of the UV radiation source 142 for irradiation separate from the Kelvin probe 132 that is suitable for measuring in a pulsed UV irradiation mode. However, other configurations are also possible, including UV radiation under the Kelvin probe, as illustrated in FIG. 2, using the UV radiation source 146. This configuration is suitable also for a continuous UV irradiation mode. Standard high precision Kelvin probes can use gold electrodes that are nontransparent. In cases where the Kelvin probe electrode 132 is nontransparent, a low angle radiation from the side can be used as schematically shown in Fig. 2 for UV source 146. In some implementations, the UV irradiation under the probe can include multiple sources like the source 146 (e.g. 2, 3 or 4 sources) directing low angle radiation from different sides of the probe. Multiple sources can improve uniformity of irradiation across the region under test. In these cases, the Kelvin probe 132 can be positioned further up above the wafer surface for uniform radiation, at a distance such as, 0.8 mm to 1 mm. For precise standard CnCV surface voltage measurement, the Kelvin probe 132 can be in a down position such as 0.2 mm above the wafer surface. Such a position can be also used in the approach for surface voltage measurement performed in the dark, before and after UV radiation pulses. The probe positioning can be done, for example, by vertical repositioning of the wafer with respect to Kelvin probe electrode 132. Repositioning can be done using the computer controlled movement of the stage 112 in FIG. 1 and in FIG. 2.

In some implementations, a transparent Kelvin probe with UV radiation through the electrode can also be used. In general, high uniformity of UV radiation may be easier to achieve in case of separate UV radiation with the source 142 shown in FIG. 1. However, the low angle side radiation under a probe with source 146 in FIG. 2 can be optimized to provide sufficiently uniform UV irradiation for precise measurement in continuous UV radiation.

Wide band gap (WBG) semiconductor characterization can be performed using system 100, with a pulsed deep ultra-violet radiation source 142 and radiation control module 140. A 235 nm wavelength (i.e., 5.3 eV photon energy) UV LED can be effectively used for WBG semiconductors, such as SiC, GaN, AlGaN and the AlGaN/GaN HEMT structure. The range of incident photon flux, *Φ*, in UV radiation pulses can be in a range from 10¹² to 10¹⁴ incident photons per cm²s. Near surface excitation of the electron-hole pairs is a necessary condition to create a strictly linear UV induced corona charge neutralization effect illustrated in FIG. 3. In the linear neutralization effect the UV radiation pulses neutralize deposited corona charge in incremental steps with a magnitude Δ*Q* being a linear function of the pulse duration, Δ*tₚ,* and the incident photon flux, *Φ*. In the linear relationship Δ*Q = f_{cal} ·* Δ*tₚ,* the *f_{cal}* is the calibration constant that is proportional to the incident photon flux, *Φ* in the radiation pulses. The LED radiation source 142 in FIG. 1 and 146 in FIG. 2, respectively, can incorporate a narrow band pass filter to eliminate longer wavelength radiation which causes distortion to the linear neutralization effect. The long wavelength radiation, for example, with wavelengths λ = 325 nm or λ = 355 nm if present, would produce a different exponential charge neutralization dependence on the illumination time employed in US12,027,430B1 and US12,154,833B2 for a different doping measurement principle, based on photoneutralization time constant of an exponential effect. To eliminate this and other interfering effects of stray light, system 100 is placed in a container to block out stray light and stray UV radiation.

For a precisely controlled linear neutralization UV-induced effect, the UV pulsed signal power supply control in module 140 shall produce accurate pulses with precisely controlled pulse duration and magnitude of UV photon flux. For pulses with a typical duration range Δ*tₚ,* from 1 ms to 20 ms, a pulse duration precision of ± 2 µs is recommended. This is achieved using precise pulse triggering control by module 140. This together with UV LED power supply current magnitude control with 0.01% precision in module 140 enables to obtain precise corona charge neutralization steps as needed for high precision determination of differential capacitance for characterization of WBG semiconductor wafers and structures.

For noncontact surface voltage measurement, an accurate and fast-responding Kelvin probe is preferred, such as a probe with a time constant of about 3 ms to 5 ms with 0.2 mV precision. A surface voltage measuring range from -100 V to+ l00 V is typical for corona charge biasing to deep depletion for n-type (negative bias) and p-type (positive bias) semiconductors. An electrode diameter of 1 mm to 2 mm, for example, is suitable for measuring surface voltages in the uniform center region of the corona charged and illuminated area.

Corona charging is realized using a corona discharge in air produced by a high DC voltage applied from power supply 122 to discharge electrode 128. The negative polarity discharge in air produces ${CO}_{3}^{-}$ ions, while the positive polarity discharge produces (*H₂O*)*ₙ H⁺* ions. The corona discharge electrodes (a needle for point charging or a wire for whole wafer charging) can be confined in an enclosure and the ion deposition is not field driven; instead, ions diffuse to the wafer surface through an aperture opening. Considering the short mean free path of ~10⁻⁵ cm at room atmosphere, the ions lose kinetic energy and become thermalized before reaching the semiconductor surface. Such a configuration enables noninvasive corona charge biasing. Precise corona charging is typically performed in a cleanroom environment with controlled humidity and temperature. Control of the deposited corona charge density is realized by setting the corona power supply 122 high voltage, the discharge current, the deposition time period and the distance between corona source and the wafer. The size of the charged spot can be increased or decreased by increasing or decreasing the source to wafer distance. The deposition time period can be about 1 second or less, such as 0.5 seconds. The deposited charge density dose, *Q_{C},* is precisely calibrated and it can be in-situ monitored with the coulombmeter 114.

For the present application, the range of corona charging magnitude extends from about 1 x 10¹² q/cm² up to about 2 x 10¹³ q/cm² and the charging can be realized in a single charging step. The charge deposited on the surface at test site 126 is mirrored as opposite charge in the semiconductor surface space charge region and acts as an electrical bias. The charging dose is much larger than the initially present surface charge, typically about 1 x 10¹¹ q/cm². Thus, depending on the doping concentration, *N_{D},* the charging dose, Qc can be selected to obtain a desired width of depletion *W_{D} =* | *Q_{C}*/*qN_{D}* |

Wide bandgap semiconductor devices are fabricated mostly on n-type epitaxial layers and 4H-SiC is a commonly used material. Accordingly, illustrating example results of the method are presented here for n-type 4H-SiC and negative polarity corona charging. For measuring such wafers, the method can further include stabilizing fresh epitaxial 4H-SiC wafers using a UV pretreatment chamber, that can be part of apparatus 100. Immediately after the epitaxial growth process, 4H-SiC may exhibit rapid dissipation of deposited corona charge. This is caused by surface spreading of corona deposited ions or by dark neutralization of corona ions caused by electron transfer from ions to the semiconductor. If present, this effect can interfere with measurements of the UV induced charge neutralization. Pretreatment eliminating such effects can be performed concurrently with the doping measurement on sets of multiple wafers. Such a capability can be added to an automated version of apparatus 100.

Stabilized bare surfaces of SiC in depletion typically exhibit good stability of corona charge in the dark. The large energy gap prevents thermal generation of free minority carriers that could neutralize corona charge. In the method, the charge stability in the dark after charging is verified by corresponding stability of the surface voltage. For that purpose, the method can include a prescribed period of surface voltage measurement in the dark after charging, and also after UV radiation pulses. A large dark surface voltage decay rate and a lower than nominally expected surface voltage magnitude for the deposited charge density, can be indicative of defects causing charge neutralization or dissipation and thus interfering with corona charge UV neutralization-based measurement. In such a case, the measurement can be repeated on a neighboring wafer site free of defects and with a negligible dark decay rate. In epitaxial 4H-SiC, used as an example in this disclosure, the interfering defects are device-killing triangular defects, downfall defects, or carrot defects. These defects can have submillimeter dimensions and shifting the measurement location by a distance greater than the diameter of the Kelvin probe, e.g., 3 mm to 5 mm in the case of a 2 mm diameter Kelvin probe, can be sufficient to eliminate interference.

Generally, measurements are performed under conditions when the corona charge is stable in the dark. For optimized measurement conditions, the magnitude of dark surface voltage decay, indicative of interfering effects, should be, i.e. insignificant compared to UV induced corona charge neutralization effect magnitude, e.g., in the range of about 0.01% or less.

The sequence illustrating the method and shown in FIG. 3 represents the case of linear corona charge neutralization by UV radiation pulses as used for measurement of epitaxial layers of WBG semiconductors such as n-type SiC, GaN or AlGaN.

The sequence starts with depositing negative corona charge ${Q}_{C}^{-}$ that creates the surface depletion layer with the width, *W_{D}* at a region of the wafer surface. After charge deposition the surface voltage is measured in the dark confirming stable charge, and the region is irradiated with short wavelength UV radiation pulses. To create the linear UV charge neutralization effect, the UV radiation shall have short penetration depth much shorter than *W_{D}* such as for instance, the penetration depth of 0.1µm for measuring the surface depletion range with thickness *W_{D}* of 0.5µm and larger. As illustrated in FIG. 3, the short UV radiation pulses create, under such conditions, the incremental charge steps, ΔQ, of the neutralized corona charge wherein the step increment, *ΔQ,* is a linear function of the duration, Δ*tₚ,* of UV radiation pulses in a series of pulses with a constant effective incident UV photon flux, *Φ*.

The insert in FIG. 3 illustrates the mechanism of the linear corona charge UV neutralization. In this process UV photons hv are absorbed within a short penetration depth region beneath the surface much shorter than *W_{D}.* The absorbed UV photons, such as hv = 5.3eV photons in radiation from an appropriate short wavelength UV LED source, such as for example, a 235 nm wavelength UV LED, generate electron-hole pairs in a close to surface part of the total depletion space charge layer. The pairs are separated by a strong electric field. The positive holes are directed to the surface and neutralize the negative corona charge ions. The negative electrons are directed to the electrically neutral semiconductor bulk. As a result, the surface depletion barrier decreases and corresponding increments of the surface voltage, Δ*V*, can be measured with a Kelvin probe.

The corona charge incremental steps, Δ*Q* are constant in magnitude until the last stages leading to complete a total neutralization of the deposited corona charge. The linear relationship between Δ*Q* and the pulse duration *Δtₚ* continues in this sequence as long as the surface density of corona ions remains larger than the number of incident photons in the UV radiation pulse.

The linear neutralization effect for each pulse can be described as Δ*Q* = *ηΦ Δtₚ*, where η is the quantum efficiency, *Φ* is the incident photon flux of UV radiation, and *Δtₚ* is the pulse duration. For the radiation source with a 235nm wavelength the efficiency η can be high, such as, for example, η = 0.7 that would correspond to 70 neutralized corona ions per 100 incident photons. This high efficiency enables the use of UV radiation with a low photon flux *Φ* in the range between 10¹² and 10¹⁴ photons/cm²s and short radiation pulses with a duration *Δtₚ* that can be typically between 1 ms and 30 ms, and even shorter, such as the fraction of millisecond pulses. Short pulses are useful for performing measurements substantially faster than that in standard corona noncontact C-V measurements using sequential corona charge deposition steps.

The linear neutralization of deposited corona charge realized using the continuous UV irradiation mode is shown in FIG 4. In this case, the charge neutralization proceeds linearly with irradiation time, t, and the magnitude of neutralized charge satisfies a linear dependance Δ*Q* = *ηΦt.* This is similar to Δ*Q = ηΦ*Δ*tₚ* in the pulsed UV irradiation mode. The *ηΦ* product defining the rate of charge neutralization Δ*Q*/Δ*t* that is equal to the charge neutralization calibration factor *f_{cal}* discussed elsewhere in the application.

Experimental results demonstrating the linear charge neutralization effect measured with 235 nm wavelength UV irradiation on n-type 4H-SiC are shown in FIG. 5 and in FIG. 6 for pulsed and continuous irradiation modes, respectively. Results in FIG. 5 show the effect of pulse durations Δ*tₚ* at a constant photon flux. The plot in FIG. 6 shows the charge neutralization rate vs. the photon flux, consistent with a linear dependence, confirmed by an excellent correlation factor *R*² = 0.9999.

Results like those in FIG. 5 and FIG. 6 can be used to refine measurement conditions, balancing specific demands for speed and resolution.

The sequence of measurements corresponding to the illustrations in FIG. 3 and FIG. 4 include time resolved measurements of the surface voltage response. The incremental change of the surface voltage ΔV represents the experimental variable analogous to the incremental change of the applied voltage in contact C-V techniques, such as, the mercury probe method MCV. However, in the present cases, these measurements are performed without any contact. Also similar to contact C-V, the relation between experimental variables in the present methods are described by the well-known Schottky depletion layer electrostatic relationships. Consistent with Schottky depletion layer characterization, the charge, *Q*, and the capacitance, *C*, in this description refer to values per unit surface area. The specific relationships used for example, for determining doping concentration, N_{D}, in n-type semiconductor depletion layer include the following:
a) definition of the derivative capacitance, *C*:
   $C = \frac{Δ Q}{Δ V}$ where Δ*Q* is the incremental change of the corona charge induced by the UV radiation pulse and *ΔV* is the UV induced change of the surface voltage.
b) capacitance relations to the width of the depletion layer, *W_{D}.* The latter being used as depth indicator in a dopant depth profiling:
   $C = \frac{{ε}_{S}}{{W}_{D}}$ where *ε_{S}* is permittivity of semiconductor, *ε_{S}* = *κε*₀ where *κ* is the dielectric constant of the semiconductor and the *ε*₀ is the permittivity of free space (8.854x10⁻¹⁴ F/cm).
c) 1/*C*² vs *V* relationship used for dopant concentration determination from the inverse of the slope: $1 / {C}^{2} = \frac{2}{{qε}_{S} {N}_{D}} \left(-V+{V}_{in}\right)$ *Vᵢₙ* is the initial surface voltage value without any corona charging and *q* is the elementary charge (1.602x10⁻¹⁹ C).
d) Inverse slope of 1/*C*² vs *V* plot is used for doping determination as: ${N}_{D} = \frac{2}{{qε}_{S}} ⋅ {\left(\frac{d \left(1/{C}^{2}\right)}{dV}\right)}^{- 1}$
e) doping depth profile is obtained as *N_{D} vs W_{D}.*

In certain implementations, surface charge characteristics are used to determine information about a sample. Corresponding Schottky layer electrostatic relationships for this purpose include:
f) *Q²vs. V* relationship used for dopant concentration determination: ${Q}_{D}^{2} = 2 {qε}_{S} {N}_{D} \left(-V+{V}_{in}\right)$ where |*Q_{D}*| *= Q_{C} + Qᵢₙ* ; *Qᵢₙ* is the initial surface space charge without any corona charging and the dopant concentration is determined as
g) ${N}_{D} = \frac{1}{2 {qε}_{S}} \frac{d \left({Q}_{D}^{2}\right)}{dV}$
h) The Schottky layer electrostatic relationships give the (Capacitance) x (charge) relationship to dopant concentration as: $C ⋅ {Q}_{D} = {qN}_{D}$

For monitoring the wafer relative uniformity, measurements of electrical parameters in relative units can be performed without calibration. For such measurements, the calibration constant *f_{cal}* can be taken as 1, giving the capacitance values in relative units as *Cᵣₑₗ =* Δ*tₚ*/Δ*V.* For determination of doping values in relative units the slope of ${\left(\frac{Δ V}{Δ {t}_{p}}\right)}^{2} vs V$ can be used. In corresponding doping depth profiling, the depth value is also in relative units and it is given by the relative depletion width ${W}_{D} = \frac{{ε}_{S}}{{C}_{rel}}$.

The relative values measured with a constant UV radiation photon flux, *Φ*, can be converted to absolute values using the actual *f_{cal}* value corresponding to the actual photon flux value.

Considering a scientific principle of the linear UV charge neutralization phenomenon, the calibration constant, *f_{cal}*, equals the actual rate of charge neutralization for a given specific photon flux, *Φ*, and it is exactly linear with the *Φ* as seen in FIG. 6.

According to the methods in this disclosure, the determination of *f_{cal}* can be performed using one of three example calibration procedures. A charge-based calibration procedure employs deposition of corona charge with precise in-situ monitored and prescribed calibration dose, *Q_{cal}* , increasing the surface depletion voltage from value *V*₁ to value *V*₂, measured with the Kelvin probe before and after charging. As a next step, the charged region is irradiated by UV radiation pulses with a prescribed photon flux, *Φ*, and prescribed pulse duration, Δ*tₚ.* The surface voltage, *V*, is monitored after each pulse and a calibration plot is constructed of *V* vs the net UV radiation time, *tₚ* = *Σ*Δ*tₚ*. From this plot the radiation time interval *t_{pcal}* corresponding to surface voltage change from *V*₂ back to *V*₁ is determined. This *t_{pcal}* value corresponds to UV neutralization of the charge calibration, dose *Q_{cal}.* For the linear UV neutralization condition the calibration constant is obtained as *f_{cal} = Q_{cal}*/*t_{pcal}.*

The other calibration procedure is based on a comparison of the values of capacitance. It uses the calibration reference values of capacitance in absolute units, *C_{cal}* vs voltage determined with the established CnCV technique at the same region on the wafer surface as the relative unit capacitance-voltage measured as *Cᵣₑₗ =* Δ*tₚ*/Δ*V.*The calibration factor is determined as the ratio between values of *C_{cal}* and *Cᵣₑₗ* taken at the same values of the surface voltage, *V, f_{cal} = C_{cal}*/*Cᵣₑₗ.*

The other example of the calibration procedure that can be incorporated in the sequence of doping concentration measurement uses comparison of the inverse slope of $\frac{1}{{C}^{2}} vs V$ used as a measure of *N_{D}* in the CnCV technique with the inverse slope of the ${\left(\frac{Δ V}{Δ {t}_{p}}\right)}^{2} vs V$ in the present disclosure. For calibration the uniform depth profile segment can be used. Calibration and relative slopes shall be taken at the same wafer region. The square of the calibration constant ${f}_{cal}^{2}$ in this approach can be determined using the ratio of the slopes in two measurements that reflect the ratio between corresponding doping concentrations in absolute and relative units, respectively.

In practice, in linear UV neutralization conditions, the *f_{cal}* at an incident photon flux value *Φ*₁ can be easily converted to different UV flux, *Φ*₂ as ${f}_{cal 2} = {f}_{cal 1} ⋅ \frac{{Φ}_{2}}{{Φ}_{1}}$*.*

The disclosed methods can include calculating the capacitance-voltage characteristic based on the ratio Δ*tₚ*/Δ*V.* Such a characteristic is shown in FIG. 7 for n-type SiC. In this case, the measured SiC wafer region was charged with corona to deep depletion in the dark. The corresponding surface voltage, V, after charging is -42V and it changes toward the initial near zero value in a series of UV radiation pulses neutralizing the deposited charge. As a precision illustration the entire measurement sequence was repeated using different durations Δ*tₚ* of UV radiation pulses. Consistently similar results are produced for different Δ*tₚ.* The scale on the left in FIG. 7 represents the capacitance in relative units, *Cᵣₑₗ =* Δ*tₚ*/Δ*V,* while the scale on the right represent capacitance in absolute units obtained as *C* = *f_{cal} Cᵣₑₗ.* The calibration constant *f_{cal}* = 1.47 x 10⁻⁹ C/ms-cm² was determined using the charge-based calibration procedure described elsewhere in the application.

Further application of the present C-V methods for determination of doping concentration and doping depth profiling is illustrated in FIG. 8 and FIG. 9, respectively. In FIG. 8 the $\frac{1}{{C}^{2}} vs . V$ plot is obtained from the relative unit plot $\frac{{\left(ΔV\right)}^{2}}{{\left(Δ{t}_{p}\right)}^{2}} vs V$*.* Doping concentration is determined from the inverse slope of plot in FIG. 8. The plot is linear with a constant slope, accordingly the doping in this epi wafer is uniform in depth, as seen in FIG. 9. The profile is obtained using the inverse $\frac{1}{{C}^{2}} vs V$ slope values corresponding to different voltages. The voltage values, *V*, are converted to depth using the corresponding capacitance values *C* (*V*) from FIG. 7. The capacitance provides a measure of depth that is equal to the width of depletion layer *W_{D}* (*V*) *= ε_{S}*/*C*(*V*) according to the Schottky electrostatic relationship b) given earlier in the application.

Illustration of the application of the present C-V measurement for doping characterization in a n-SiC wafer with two epi-layers is illustrated in FIG. 10 and FIG. 11. FIG. 10 shows the 1/*C*² *vs. V* plot while the corresponding doping depth profile is shown in FIG. 11.

The results in FIG. 10 were obtained using a variable UV pulse duration measurement. In this approach shorter duration pulses, Δ*tₚ* of 5 ms are used for measuring the lower doped epi-layer *N*_{*D*2} located deeper in the wafer, while longer pulses, Δ*tₚ* = 10 ms are used for the higher doped layer *N*_{*D*1} located near the wafer surface. The corresponding doping concentration profile *N_{D}* vs depth is shown in FIG. 11.

Different duration UV pulse measurements, according to the present application can be performed using one and the same calibration constant, *f_{cal}* for entire range covering both layers. This technique enables the optimization of measurements regarding the measurement speed and depth resolution in profiling.

The characterization methods in this disclosure are based on a linear neutralization of the corona charge by UV irradiation. In general, the UV-induced data (*t; V; Q*) illustrated in FIG. 12 can benefit not only C-V but also other techniques employing charge-voltage characteristics. For example, dopant concentration, N_{D}, can be determined based on Schottky layer electrostatic relationships, such as, relationships f) and g) above. The Schottky layer depletion charge, *Q_{D},* and the corresponding surface voltage, *V* data can be acquired in an irradiation time-surface voltage measurement sequence, schematically depicted in FIG. 12. A corresponding standard CnCV multi-step charging approach is represented in FIG. 12 by the (*Q_{C}; V*) set of data shown as a reference. Both methods, UV based and standard CnCV, include corona charging in the dark from the initial condition *Q_{C} =* 0 *; V = Vᵢₙ* to the deep depletion condition wherein *Q_{C} = Q_{CD} and V = V_{D}.* Thereafter, the UV irradiation neutralization of deposited charge is turned on at *t* = 0 and a time resolved monitoring of the surface voltage response is performed up to the recovery of the initial condition *Q_{C} =* 0 *; V = Vᵢₙ* that is reached at irradiation time, *t,* denoted as *t = tᵢₙ.* The irradiation time *t* during neutralization constitutes a measure of the neutralized charge in relative units that can be converted to charge in absolute units as *Q = f_{cal} · t.* The calibration factor can be determined for example using the corona charge, *Q_{CD},* deposited to create deep depletion and the UV irradiation time, *t = tᵢₙ,* for neutralizing this charge, *f_{cal} =* |*Q_{CD}*/*tᵢₙ*|.

During the UV neutralization of corona charge, the actual Schottky depletion charge, *Q_{D}* , corresponding to a given irradiation time, *t,* is determined as *Q_{D}*(*t*) *=* |*Q_{CD}*| *- f_{cal}* · *t.* The charge-voltage characteristic is then determined as the set of data [*Q_{D}*(*t*); *V*(*t*)] covering the entire neutralization range. To apply the *Q*² - *V* method for high precision doping measurements, the contribution of the initial surface charge, *Qᵢₙ* present at *Q_{C}* = 0 is estimated as the fitting parameter and it is added to the charge used in the *Q*² - *V* plot. An example of a *Q*² *- V* result is shown in FIG 13 for n-type 4H-SiC. The linear plot indicates uniform doping depth profile with dopant concentration *N_{D}* = 1.02*x*10¹⁶*cm*⁻³ determined from the slope *d*(*Q*²)/*dV* according to the Schottky depletion charge relationship, f).

The characterization of AlGaN/GaN structures for high electron mobility transistors uses the linear corona charge neutralization induced by UV radiation that for this structure generates electron-hole pairs within AlGaN barrier layer illustrated in FIGS. 14A and 14B. As the first step in the characterization process, a large negative corona charge is deposited at a region on the top surface of the structure, typically an AlGaN barrier layer. The charge depopulates the two-dimensional electron gas, 2DEG, at AlGaN/GaN interface. As illustrated in FIG. 14A, the further characterization sequence comprises irradiating the region with a series of ultraviolet (UV) radiation pulses neutralizing the deposited charge and causing repopulation of the 2DEG as illustrated in FIG. 14B. Measuring at the region before each UV pulse gives the incremental changes of the surface voltage, Δ*V*, and the average voltage, *V*, enabling the determination of the differential capacitance and the capacitance-voltage (C-V) characteristic at the region based on a series of *Δt*/Δ*V* values and corresponding surface voltage values, *V*.

For the pulsed irradiation mode with pulse duration Δ*tₚ,* the AlGaN/GaN characterization can be based on relative capacitance values *Cᵣₑₗ =* Δ*tₚ*/Δ*V* or on the calibrated values *C* = *f_{cal} · Cᵣₑₗ.* The latter gives the capacitance in absolute units.

An example of such a capacitance-voltage, C-V characteristic is shown in FIG. 15. The three AlGaN/GaN structure parameters, namely the pinch-off voltage, *Vₚ*; the AlGaN layer electrical thickness, d_{AlGaN}, and the 2DEG charge density, Q_{2DEG}, can be determined from the calibrated absolute unit C-V characteristic using standard C-V metrology procedures described in literature. The most important parameter is the pinch-off voltage. It is determined as the surface voltage value corresponding to the half capacitance value in C-V step as indicated in FIG. 15. Accordingly, the *Vₚ* can also be determined with the present method using the relative unit *Cᵣₑₗ - V* characteristic without calibration. Such direct *Vₚ* determination can be beneficial for enhanced throughput measurements and uniformity testing on AlGaN/GaN wafers.

It is a general feature of methods in the present disclosure that they enable determination of semiconductor parameters in relative units without calibration. Such relative values can be of practical importance for wafer level testing of electrical parameter uniformity. Whenever needed, the relative unit values can be converted to absolute units using a calibration constant *f_{cal}* measured at one wafer region and applied to measurements at other regions.

Characterization of AlGaN/GaN HEMT structures as described here can be performed with high measurement speed using the continuous mode of UV irradiation under the probe and time resolved monitoring of the surface voltage during irradiation. The continuous UV irradiation mode provides around 2 orders of magnitude improvement in throughput with a measurement time around 10s/site compared to a 4min/site measurement time for the standard CnCV technique with incremental corona charge based HEMT measurement. Digitized (t,V) results can be used to determine the structure parameters as it is illustrated in FIG. 16 for measurement at a region of an AlGaN/GaN HEMT structure wafer.

The pinch off voltage, *Vₚ*, is determined as the surface voltage at the intersection point of the two extrapolated *t - V* lines, i.e., the high slope line corresponding to populated two-dimensional gas near the initial condition and the low slope line corresponding to depopulated two-dimensional gas in higher negative surface voltage range. The *Vₚ* constitutes a demarcation point separating the filled and emptied two-dimensional potential well formed on GaN side of AlGaN/GaN heterointerface. Two other parameters determined from *t - V* plot include: 1. Two-dimensional electron gas (2DEG) sheet charge Q_{2DEG} that can be obtained using the UV irradiation time interval between the pinch-off condition and the initial condition, *Q*₂*_{DEG} = t_{cal}*(*tᵢₙ* - *tₚ*); and 2. The AlGaN electrical thickness can be obtained from the slope of the *t - V* line in the populated 2DEG range that gives the AlGaN layer capacitance, *C_{AlGaN}* = *f_{cat}*(Δ*t*/Δ*V*). Values in relative units are converted to absolute units using the calibration factor *f_{cal}.* However, the relative values of parameters without calibration can be valuable for wafer uniformity testing in AlGaN/GaN HEMT fabrication.

### EMBODIMENTS

Although the present invention is defined in the claims, it should be understood that the present invention can also (alternatively) be defined in accordance with the following embodiments:
Embodiment 1. A method of characterizing a wide-bandgap semiconductor sample, the method including: depositing a corona charge on a surface of the sample in the dark to bias a region of the semiconductor sample to depletion; measuring a surface voltage at the region in the dark after depositing the corona charge; irradiating the region with ultraviolet (UV) radiation to neutralize the deposited charge, the UV radiation having a prescribed wavelength *λ*, and a photon flux *Φ*, in a range necessary for linear corona charge neutralization, wherein a magnitude of neutralized corona charge, Δ*Q,* is linear with a duration of the UV irradiation, *t*; measuring a time resolved surface voltage, V, response to the UV irradiation at the region and determining a corresponding irradiation time *t,* and the surface voltage V, set of data (*t* ; *V*); constructing an irradiation time-voltage (*t - V*) characteristic at the region using the set of the data (*t* ; *V*); calculating a charge-voltage (*Q - V)* characteristic at the region based on the (*t - V*) characteristic with the irradiation time converted to charge using a calibration constant *f_{cal}* for the prescribed value of photon flux, *Φ*, relating the neutralized charge magnitude Δ*Q* to the duration of UV irradiation as Δ*Q = f_{cal}* · *t*; determining a differential capacitance as *C* = *f_{cal}* Δ*t*/Δ*V* and constructing a capacitance-voltage (*C - V*) characteristic at the region using the irradiation time and surface voltage set of data (*t* ; *V*); and determining values of one or more parameters of a semiconductor sample at the region based on the *t - V* characteristic, *Q - V* characteristic and/or the *C - V* characteristic.
Embodiment 2. The method of embodiment 1, wherein the calibration constant *f_{cal}* is determined as *f_{cal}* = *Q_{cal}*/*t_{cal}* based on the irradiation time, *t_{cal},* required to neutralize a known increment of corona charge, *Q_{cal}.*
Embodiment 3. The method of embodiments 1 or 2, wherein differential capacitance values are determined in relative units as *Cᵣₑₗ =* Δ*tₚ*/Δ*V* and the determined values of parameters based on capacitance are in relative units.
Embodiment 4. The method of embodiments 1, 2, or 3, wherein the region is irradiated with a series of UV radiation pulses sufficient to neutralize the deposited charge in a series of incremental steps, each UV irradiation pulse having a duration Δ*tₚ* with a prescribed wavelength, *λ*, and a photon flux, *Φ*, in a range necessary for linear corona charge neutralization, wherein the increments of neutralized corona charge, Δ*Q,* are linear with the pulse duration, Δ*tₚ.*
Embodiment 5. The method of embodiment 4, wherein measuring a time resolved surface voltage, *V*, response to the UV irradiation includes measuring the surface voltage at the region in the dark before and after each UV radiation pulse and determining an average surface voltage value, *V*, for the pulse and an incremental change of the surface voltage, Δ*V*, corresponding to the pulse.
Embodiment 6. The method of embodiment 5, wherein determining the *C-V* characteristic at the region includes determining a relative *Cᵣₑₗ* value in arbitrary units for a given UV radiation pulse from the ratio $\frac{Δ {t}_{p}}{Δ V}$ and using an average *V* value as the surface voltage value corresponding to a given pulse.
Embodiment 7. The method of embodiment 6, wherein the C- *V* characteristic in absolute units is obtained by converting *Cᵣₑₗ* values into capacitance, C, in absolute units using a calibration constant *f_{cal}* value at the prescribed UV wavelength, *λ*, and a photon flux, *Φ*, relating a neutralized charge increment Δ*Q* to the pulse duration as Δ*Q* = *f_{cal}* · Δ*tₚ* and *C* is determined according to the relationship: *C = f_{cal}* · Δ*tₚ*/Δ*V.*
Embodiment 8. The method of embodiment 4, wherein Δ*tₚ* is in a range from 0.5 milliseconds to 30 milliseconds.
Embodiment 9. The method of any one of the prior embodiments, wherein the calibration constant *f_{cal}* is determined for the prescribed UV wavelength, *λ*, and photon flux value, *Φ*, and the *f_{cal}* determination includes using a known reference calibration corona charge or using a known reference absolute unit capacitance or using a known reference dopant concentration.
Embodiment 10. The method of embodiment 9, wherein a second calibration constant *f*_{*cal*2} for a different photon flux value *Φ*₂ is determined from the calibration constant *f*_{*cal*1} value at a photon flux *Φ*₁ as ${f}_{cal 2} = {f}_{cal 1} \frac{{Φ}_{1}}{{Φ}_{2}}$.
Embodiment 11. The method of one of the prior embodiments, wherein the calibration constant *f_{cal}* value that is determined at one region of the sample is used at other regions of the semiconductor sample when applied to measurements at multiple regions on the semiconductor sample.
Embodiment 12. The method of one of the prior embodiments, wherein parameter values in relative or in absolute units are determined at a prescribed number and coordinates of regions on the semiconductor sample.
Embodiment 13. The method of embodiment 12, wherein the parameter values determined at multiple regions are used to construct maps of parameters on the semiconductor sample.
Embodiment 14. The method of one of the prior embodiments, wherein the region is irradiated with continuous UV radiation under a surface voltage probe while measuring the surface voltage.
Embodiment 15. The method of one of the prior embodiments, wherein the charge values Q are determined in relative units based on the irradiation time, *t,* as *Qᵣₑₗ* = *t* and the determined parameter values are in relative units.
Embodiment 16. The method of one of the prior embodiments, wherein the semiconductor sample is a wafer including an AlGaN/GaN HEMT structure and the parameters are calculated from the (*t - V*) and (*Q - V*) characteristics.
Embodiment 17. The method of embodiment 16, wherein the parameters include a pinch-off voltage, *Vₚ*, calculated as the surface voltage value at the interception point of the extrapolated high and low sloped *t - V* lines corresponding to a populated and depopulated 2DEG, respectively.
Embodiment 18. The method of embodiment 17, wherein the parameters include a 2DEG sheet charge density, *Q*₂*_{DEG},* calculated as *Q*_{2*DEG*} = *f_{cal}*(*tᵢₙ - tₚ*) based on the irradiation time interval (*tᵢₙ* - *tₚ*) between an initial surface voltage *Vᵢₙ* and a surface voltage equal to *Vₚ.*
Embodiment 19. The method of embodiment 17, wherein the parameters include an electrical thickness of an AlGaN layer of the wide-bandgap semiconductor AlGaN/GaN HEMT structure sample calculated based on the slope $\frac{Δ t}{Δ V}$ of the *t - V* characteristic in the high slope range corresponding to a populated 2DEG.
Embodiment 20. The method of one of the prior embodiments, wherein the semiconductor sample includes a wide bandgap semiconductor selected from the group consisting of SiC (such as 3C-SiC, 4H-SiC, 6H-SiC); AlₓGa₁₋ₓN with x from [0 to 0.5]; AlₓGa₁₋ₓN/GaN HEMT structures; Ga₂O₃ and other wide bandgap semiconductors with a bandgap energy of about 2eV or larger.
Embodiment 21. The method of one of the prior embodiments, wherein the parameters include dopant concentration values and depth profiling calculated using the (*C* - *V*) characteristic and determined based on the inverse of the 1/*C*² *vs V* slope where *C* = *f_{cal}*(Δ*t*/Δ*V*) and where the depth is determined by the width of depletion layer as ${W}_{D} = \frac{{ε}_{S}}{{f}_{cal} \left(Δt/ΔV\right)}$ .
Embodiment 22. The method of one of the prior embodiments, wherein the parameters include dopant concentration values and depth profiling calculated using the (*Q* - *V*) characteristic and determined based on the *Q*² *vs V* slope where *Q* = *f_{cal} · t.*
Embodiment 23. The method of one of the prior embodiments, wherein the wavelength *λ* is about 250 nm or less and the photon flux *Φ* is in a range from 1x10¹² to 1x10¹⁴ photons per cm².
Embodiment 24. A system, including: a corona charge source; a noncontact surface voltage measurement probe; a UV radiation source for pulsed and continuous irradiation; a UV detector arranged to monitor a photon flux from the radiation source; a moveable chuck configured to support the sample relative to the corona charge source, the surface voltage measurement probe and the UV radiation source; and a computer controller in communication with the surface voltage measurement probe, the corona charge source, the UV radiation source, and the moveable wafer chuck, the computer controller being programmed to cause the system to: (i) deposit, using the corona charge source, a corona charge on a surface of the sample in the dark to bias a region of the semiconductor sample to depletion; (ii) measure, using the surface voltage measurement probe, a surface voltage at the region in the dark after depositing the corona charge; (iii) irradiate, using the UV radiation source, the region with ultraviolet (UV) radiation to neutralize the deposited charge, the UV radiation having a prescribed wavelength *λ*, and a photon flux *Φ*, required for linear corona charge neutralization, wherein a magnitude of neutralized corona charge, Δ*Q,* is linear with a duration of the UV irradiation, *t;* (iv) measure, using the surface voltage measurement probe, the surface voltage, V, response to the UV irradiation at the region and determining a corresponding irradiation time *t*, and the surface voltage V, set of data (*t* ; *V*) and constructing an irradiation time-voltage (*t - V*) characteristic at the region using the set of the data (*t* ; *V*); (v) calculate a charge-voltage (Q *- V)* characteristic at the region based on the *(t - V)* characteristic with the irradiation time converted to charge using a calibration constant *f_{cal}* for the prescribed photon flux, *Φ*, relating the neutralized charge magnitude Δ*Q* to the duration of UV irradiation as Δ*Q* = *f_{cal} · t*; (vi) calculate a differential capacitance as *C* = *f_{cal}* Δ*t*/Δ*V* and constructing a capacitance-voltage (*C - V)* characteristic at the region using the irradiation time and surface voltage set of data (*t* ; *V*); and (vii) determine one or more parameters of the sample at the region based on the (*t - V*) characteristic, (*Q - V*) characteristic and/or the (*C - V*) characteristic.
Embodiment 25. The system of embodiment 24, wherein the surface voltage measurement probe is a non-contact Kelvin probe.
Embodiment 26. The system of embodiments 24 or 25, wherein the surface voltage measurement probe includes a nontransparent electrode and the UV radiation source is arranged to direct radiation at an acute angle to the sample surface at the region positioned under the probe.

A number of embodiments are described. Other embodiments are in the following claims.

## Claims

1. A method of characterizing a semiconductor sample, the method comprising:
depositing a corona charge on a surface of the semiconductor sample;
irradiating a region with ultraviolet (UV) radiation for a duration, *t*, to neutralize the deposited corona charge;
measuring a time resolved surface voltage, *V*, response to the UV irradiation at the region; and
determining values of one or more parameters of the semiconductor sample at the region based on the duration of the UV irradiation, *t*, and the time resolved surface voltage, *V*, and at least one of a value of a neutralized corona charge, Δ*Q,* and a differential capacitance value, *C*.

2. The method of claim 1, wherein the UV radiation has a prescribed wavelength, *λ*, and a photon flux, *Φ*, in a range that produces linear corona charge neutralization, wherein a magnitude of neutralized corona charge, Δ*Q,* is linear with the duration of the UV irradiation, *t.*

3. The method of claim 2, wherein the at least one of the value of the neutralized corona charge, Δ*Q,* and the differential capacitance value, *C*, is determined using a calibration constant *f_{cal}* based on an irradiation time, t_{cal}, required to neutralize a known increment of corona charge, *Q_{cal},* for a prescribed value of photon flux, *Φ*, of the UV radiation.

4. The method of any of claims 1 to 3, wherein determining the values of one or more parameters of the semiconductor sample at the region is based on at least one of a charge-voltage (Q *- V*) characteristic at the region determined based on the value of the neutralized corona charge, Δ*Q,* and a capacitance-voltage (*C - V*) characteristic at the region determined based on the differential capacitance value, *C*.

5. The method of any of claims 1 to 4, wherein irradiating the region with UV radiation to neutralize the deposited corona charge comprises using a series of UV radiation pulses sufficient to neutralize the deposited corona charge in a series of incremental steps, each UV irradiation pulse having a duration, Δ*tp,* with a prescribed wavelength, *λ*, and a photon flux, *Φ*, in a range that produces linear corona charge neutralization, wherein a magnitude of the neutralized corona charge, Δ*Q,* is linear with the UV radiation pulse duration, Δ*tₚ*.

6. The method of claim 5, wherein measuring the time resolved surface voltage, *V*, response to the UV irradiation comprises measuring a surface voltage at the region before and after each UV radiation pulse.

7. The method of any of claims 1 to 4, wherein irradiating the region with UV radiation to neutralize the deposited corona charge comprises using continuous UV radiation under a surface voltage probe while measuring the time resolved surface voltage, *V*.

8. The method of any of claims 1 to 7, wherein the semiconductor sample is a wafer comprising an AlGaN/GaN HEMT structure and the values of the one or more parameters are determined from an irradiation time-voltage (*t - V*) characteristic determined based on the duration of the UV irradiation *t* and the time resolved surface voltage, *V*, and a charge-voltage (*Q - V*) characteristic determined based on the value of the neutralized corona charge, Δ*Q.*

9. The method of any of claims 1 to 8, wherein the semiconductor sample comprises a wide bandgap semiconductor with a bandgap energy of 2eV or larger.

10. The method of any of claims 1 to 9, wherein the values of the one or more parameters comprise dopant concentration values and depth profiling determined using a capacitance-voltage (*C - V*) characteristic determined based on the differential capacitance value, *C*, or using a charge-voltage (*Q - V)* characteristic determined based on the value of the neutralized corona charge, Δ*Q.*

11. A system for characterizing a semiconductor sample, comprising:
a corona charge source that deposits a corona charge on a surface of the semiconductor sample;
a surface voltage measurement probe that measures a time resolved surface voltage, *V*, in a region on the semiconductor sample;
an ultraviolet (UV) radiation source that irradiates the region with UV radiation for a duration, *t*, to neutralize the deposited corona charge; and
a computer controller in communication with the surface voltage measurement probe, the corona charge source, and the UV radiation source, and configured to determine values of one or more parameters of the semiconductor sample at the region based on the duration of the UV irradiation, *t*, and the time resolved surface voltage, *V*, and at least one of a value of a neutralized corona charge, Δ*Q,* and a differential capacitance value, *C*.

12. The system of claim 11, wherein the UV radiation has a prescribed wavelength *λ*, and a photon flux *Φ*, in a range that produces linear corona charge neutralization, wherein a magnitude of neutralized corona charge, Δ*Q,* is linear with the duration of the UV irradiation, *t.*

13. The system of claim 11 or claim 12, wherein the values of one or more parameters of the semiconductor sample at the region are determined based on at least one of a charge-voltage (*Q - V*) characteristic at the region determined based on the value of the neutralized corona charge, Δ*Q,* and a capacitance-voltage (*C - V*) characteristic at the region determined based on the differential capacitance value, *C*.

14. The system of any of claims 11 to 13, wherein the UV radiation source that irradiates the region with UV radiation to neutralize the deposited corona charge produces a series of UV radiation pulses sufficient to neutralize the deposited corona charge in a series of incremental steps, each UV irradiation pulse having a duration, Δ*tp,* with a prescribed wavelength, *λ*, and a photon flux, *Φ*, in a range that produces linear corona charge neutralization, wherein a magnitude of the neutralized corona charge, Δ*Q,* is linear with the UV radiation pulse duration, Δ*tₚ.*

15. The system of any of claims 11 to 13, wherein the UV radiation source that irradiates the region with UV radiation to neutralize the deposited corona charge produces continuous UV radiation under the surface voltage measurement probe while measuring the time resolved surface voltage, *V*.
